(19) Europäisches Patentamt
European Patent Office
Office européen des brevets

(11) **EP 1 764 911 A2**

(12) **EUROPEAN PATENT APPLICATION**

(43) Date of publication:
**21.03.2007 Bulletin 2007/12**

(51) Int Cl.:
**H03B 27/00** (2006.01)    **H03B 5/12** (2006.01)

(21) Application number: **06120156.2**

(22) Date of filing: **05.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.09.2005 KR 20050085768**

(71) Applicant: **SAMSUNG ELECTRONICS CO., LTD.**
**Suwon-si**
**Gyeonggi-do 442-742 (KR)**

(72) Inventors:
• **Ryu, Jae-young**
**Yeongtong-gu,**
**Suwon-si,**
**Gyeonggi-do (KR)**
• **Kim, Dae-ki**
**Bundang-gu,**
**Seongnam-si,**
**Gyeonggi-do (KR)**
• **Son, Ju-ho**
**Suwon-si,**
**Gyeonggi-do (KR)**

(74) Representative: **Brandon, Paul Laurence**
**APPLEYARD LEES**
**15 Clare Road**
**Halifax HX1 2HY (GB)**

(54) **Quadrature voltage controlled oscillator and wireless transceiver including the same**

(57)    A quadrature voltage-controlled oscillator includes an oscillation module (410, 610) that provides a first signal and a second signal having predetermined frequencies, and a coupling module (420, 620) that couples the first signal and the second signal in a manner such that the second signal has a quadrature phase difference with respect to the first signal.

**FIG. 5**

EP 1 764 911 A2

## EP 1 764 911 A2

**Description**

The present invention relates to quadrature voltage-controlled oscillators and transceivers including the same.

Generally, voltage-controlled oscillators modulate a frequency by changing the capacitance of a variable capacitor through a voltage control. The voltage controlled oscillator, which is necessary for all electronic communication systems, is used to up-convert or down-convert a frequency corresponding to a predetermined signal.

According to the signal environment, which includes a single intermediate frequency (IF), a double IF or direct conversion, a wireless transceiver may include a predetermined number of voltage controlled oscillator circuits.

Modulation methods require a quadrature signal. In the case of direct conversion (or zero IF), a quadrature part oscillating frequency is necessary for recovering an original signal. A quadrature voltage controlled oscillator generates the frequency.

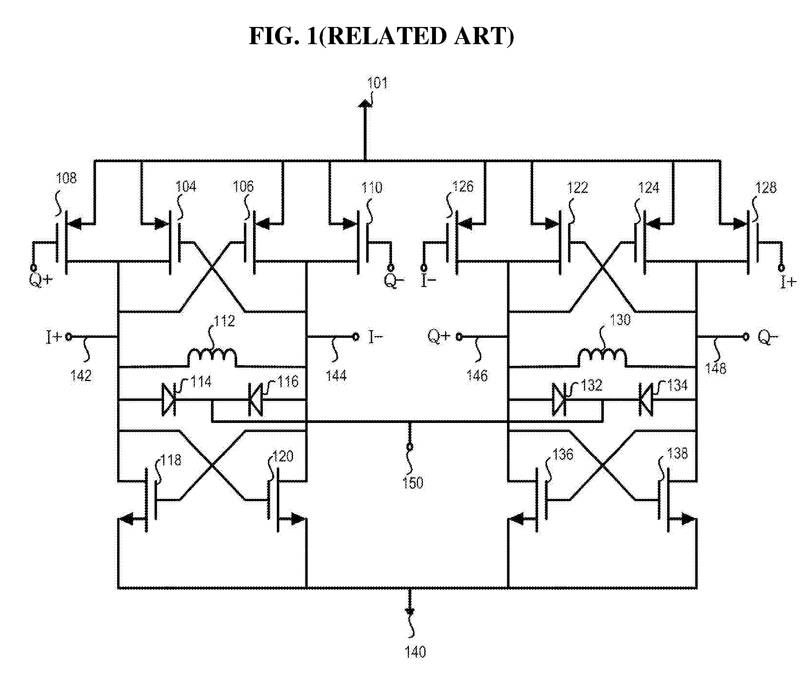

FIG. 1 is a circuit diagram showing a structure of a related art quadrature voltage-controlled oscillator.

Referring to FIG. 1, a quadrature voltage-controlled oscillator includes in-phase blocks 104, 106, 118, 120, 142 and 144, quad-phase blocks 122, 124, 136, 138, 146 and 148, coupling blocks 108, 110, 126 and 128 and inductor-capacitor (LC) tank blocks 112, 114, 116, 130, 132 and 134.

Here, NMOS transistors 118 and 120, and PMOS transistors 104 and 106 are used for in-phase oscillation. NMOS transistors 136 and 138, and PMOS transistors 122 and 124 are used for quad-phase oscillation.

In addition, PMOS transistors 108, 110, 126, and 128 are used for coupling to generate a quadrature signal.

Resonance is generated in the LC tank that consists of inductors 112 and 130 and diodes 114, 116, 132, and 134. In this case, the diodes refer to varactor diodes. The oscillation frequency is determined by changing a capacitance value according to the voltage supplied via a terminal 150.

In addition, each of terminals 142, 144, 146, and 148 refers to an in-phase positive signal output terminal, an in-phase negative signal output terminal, a quad-phase positive signal output terminal, and a quad-phase negative signal output terminal, respectively. A terminal 140 is connected to a DC ground.

In FIG. 1, circuits of the in-phase and quad-phase are identical to each other, and each generates a differential signal having a phase difference of 180 degrees. The differential signals are denoted by I+, I-, Q+, and Q-.

The quadrature voltage-controlled oscillator illustrated in FIG. 1 is resonated by negative resistance generated by an upper PMOS transistor and a lower NMOS transistor. The resonance frequency is determined by the LC tank block as above.

The resonance frequency determined by the LC tank block can be calculated from Equation (1).

$$f = \frac{1}{2\pi\sqrt{LC}} \qquad (1),$$

where L denotes the inductance of the inductors 112 and 130, and C denotes the capacitance of the varactor diodes 114, 116, 132 and 134.

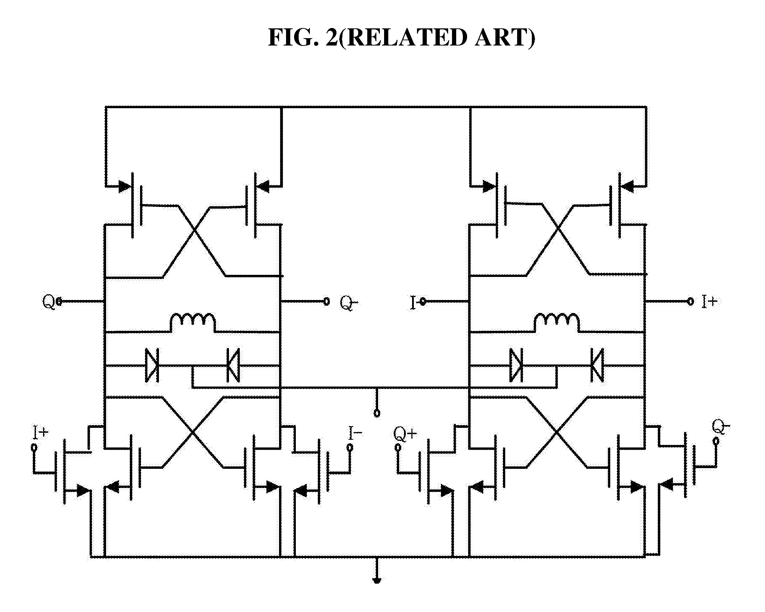

In FIG. 1, in addition to generating a desired frequency by using an NMOS transistor, and a coupling circuit configured for generating a quadrature frequency by using a PMOS transistor, a desired frequency may also be generated by using a PMOS transistor and a coupling circuit configured for generating a quadrature frequency by using an NMOS transistor, which is illustrated in FIG. 2.

The quadrature voltage-controlled oscillator illustrated in FIG. 2 and the quadrature voltage-controlled oscillator illustrated in FIG. 1 have different transistors used for oscillation or coupling. However, functions of each device are identical.

According to the structure of the related art quadrature voltage-controlled oscillator illustrated in FIGS 1 and 2, a phase noise and a phase error of the whole circuit are increased because noise components caused by the couplings are added to the circuit.

Due to the complexity of the circuit, a phase noise and a phase error may be increased because of conflict of differential quadrature signal lines when a layout is performed.

Preferred embodiments of the present invention aim to provide a quadrature voltage-controlled oscillator that generates a quadrature signal which has a reduced phase noise and phase error while maintaining its power consumption and frequency tuning range, and a wireless transceiver including the same.

Preferred embodiments of the present invention also aim to provide a quadrature voltage-controlled oscillator which minimizes noise effects caused by coupling by separating an oscillating unit from a coupling unit.

According to an aspect of the present invention, there is provided a quadrature voltage-controlled oscillator including an oscillation module that oscillates a first signal and a second signal having predetermined frequencies, and a coupling module that couples the first signal and the second signal so that the second signal has a quadrature phase difference with respect to the first signal.

According to another aspect of the present invention, there is provided a wireless transceiver including a low-noise amplifier that amplifies radio frequency (RF) signals, a quadrature voltage-controlled oscillator that provides oscillation signals by separating an oscillating area from a coupling area, a mixer that outputs baseband signals by mixing the amplified RF signal with the oscillation signal, and a baseband processor that processes the output baseband signals.

Further features of the present invention are set out in the amended claims.

The present invention will become more apparent by describing in detail exemplary embodiments thereof with reference to the attached drawings, in which:

FIG. 1 is a circuit diagram showing a structure of a related art quadrature voltage controlled oscillator;

FIG. 2 is a circuit diagram showing a structure of another related art quadrature voltage controlled oscillator;

FIG. 3 is a block diagram showing a structure of a wireless transceiver according to an exemplary embodiment of the present invention;

FIG. 4 is a block diagram showing a structure of a quadrature voltage-controlled oscillator according to an exemplary embodiment of the present invention;

FIG. 5 is an exemplary circuit diagram of the quadrature voltage-controlled oscillator illustrated in FIG. 4;

FIG. 6 is a circuit diagram showing a structure of a quadrature voltage-controlled oscillator according to another exemplary embodiment of the present invention;

FIG. 7 is an exemplary circuit diagram of the quadrature voltage-controlled oscillator illustrated in FIG. 6;

FIGS. 8A and 8B are graphs showing a result of a simulation according to the related art and the present invention.

Aspects of the present invention and methods of accomplishing the same may be understood more readily by reference to the following detailed description of the preferred embodiments and the accompanying drawings. The present invention may, however, be embodied in many different forms and should not be construed as being limited to the exemplary embodiments set forth herein. Rather, these embodiments are provided so that this disclosure will be thorough and complete and will fully convey the concept of the invention to those skilled in the art, and the present invention will only be defined by the appended claims. Like reference numerals refer to like elements throughout the specification.

The present invention is described hereinafter with reference to flowchart illustrations of user interfaces, methods, and computer program products according to exemplary embodiments of the invention. It should be understood that each block of the flowchart illustrations, and combinations of blocks in the flowchart illustrations, can be implemented by computer program instructions. These computer program instructions can be provided to a processor of a general purpose computer, special purpose computer, or other programmable data processing apparatus to produce a machine, such that the instructions, which are executed via the processor of the computer or other programmable data processing apparatus, create means for implementing the functions specified in the flowchart block or blocks. These computer program instructions may also be stored in a computer usable or computer-readable memory that can direct a computer or other programmable data processing apparatus to function in a particular manner, such that the instructions stored in the computer usable or computer-readable memory produce an article of manufacture including instruction means that implement the function specified in the flowchart block or blocks. The computer program instructions may also be loaded into a computer or other programmable data processing apparatus to cause a series of operational steps to be performed in the computer or other programmable apparatus to produce a computer implemented process such that the instructions that execute in the computer or other programmable apparatus provide steps for implementing the functions specified in the flowchart block or blocks.

And each block of the flowchart illustrations may represent a module, segment, or portion of code, which includes one or more executable instructions for implementing the specified logical function(s). It should also be noted that in some alternative implementations, the functions noted in the blocks may occur out of the order. For example, two blocks shown in succession may in fact be executed substantially concurrently or the blocks may sometimes be executed in the reverse order, depending upon the functionality involved.

A quadrature voltage controlled oscillator and a transceiver including the same according to an exemplary embodiment of this invention will now be described more fully with reference to the accompanying drawings.

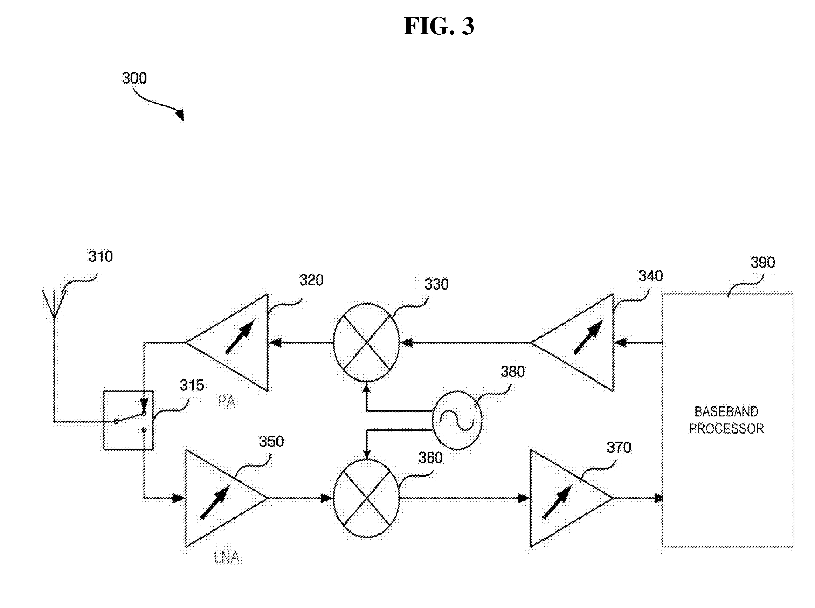

FIG. 3 is a block diagram showing a structure of a wireless transceiver according to an exemplary embodiment of the present invention. For convenience, a transmitting process and a receiving process of a wireless transceiver 300 will be separately described.

The operation of a wireless transceiver 300 in a transmitting process according to an exemplary embodiment of the present invention will be described in the following.

A baseband signal output by a baseband processor 390 is amplified in a baseband amplifier 340. In this case, the baseband signal includes an in-phase signal and a quadrature-phase signal. The amplified baseband signal is combined with an oscillation signal generated in a quadrature voltage-controlled oscillator 380 according to an exemplary embodiment of the present invention in an up-mixer 330, and becomes a radio frequency (RF) signal. In this case, the quadrature voltage-controlled oscillator 380 provides in-phase and quadrature-phase oscillation frequencies at the same time, and an oscillation circuit and a coupling circuit composing the quadrature voltage-controlled oscillator are separated from each other. The RF signal is amplified in a power amplifier 320, and output to a wireless channel via an antenna 310.

The power amplifier 320 used in the transmitting process may include several stages of amplifiers used to reduce distortion and to obtain high benefits.

The operation of a wireless transceiver 300 in the receiving process will now be described in the following.

The RF signal input by the wireless channel via the antenna 310 is amplified by a low noise amplifier 350.

The amplified RF signal becomes a baseband signal via a down-mixer 360, and then is amplified in a baseband amplifier 370.

In this case, a quadrature voltage-controlled oscillator 380 provides in-phase and quadrature-phase oscillation frequencies to the down-mixer 360 at the same time. In addition, the signal amplified in the baseband amplifier 370 includes an in-phase signal and a quadrature-phase signal. Each differential signal has a phase difference of 180 degrees, and may be provided to the baseband processor 390.

A switch 315 stops an RF signal output from the power amplifier 320 from being input to the low noise amplifier 350, and an RF signal input via the antenna 310 from being transmitted to the power amplifier 320. In a full duplex method, a duplexer is used instead of the switch 315.

The antenna 310, the switch 315, the power amplifier 320, and the low noise amplifier 350 may be collectively referred to as an "RF module".

A quadrature voltage-controlled oscillator according to an exemplary embodiment of the present invention may be applied to any wireless transceiver if a circuit needs a quadrature signal.

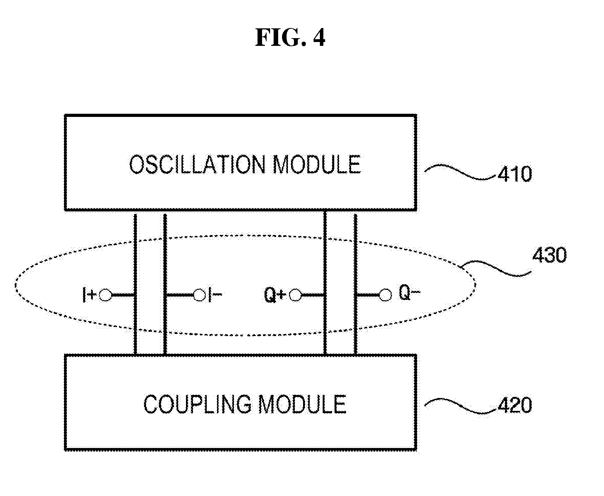

FIG. 4 is a block diagram showing a structure of a quadrature voltage-controlled oscillator according to an exemplary embodiment of the present invention.

Referring to FIG. 4, the quadrature voltage-controlled oscillator according to an exemplary embodiment of the present invention includes an oscillation module and a coupling module 420 for generating a quadrature frequency, which is located at the bottom of the oscillation module 410.

The term "module", as used herein, means, but is not limited to, a software or hardware component, such as a Field Programmable Gate Array (FPGA) or an Application Specific Integrated Circuit (ASIC), which performs certain tasks. A module may advantageously be configured to reside on the addressable storage medium and configured to be executed on one or more processors. Thus, a module may include, by way of example, components, such as software components, object-oriented software components, class components and task components, processes, functions, attributes, procedures, subroutines, segments of program code, drivers, firmware, microcode, circuitry, data, databases, data structures, tables, arrays, and variables. The functionality provided for in the components and modules may be combined into fewer components and modules, or further separated into additional components and modules.

The coupling module 420 generates a quadrature frequency using output signals of the quadrature voltage-controlled oscillator I+, I-, Q+, and Q- signals 430. Accordingly, the oscillation module 410 and the coupling module 420 are separated from each other, and a noise caused by coupling does not influence the phase noise of the oscillation module 410.

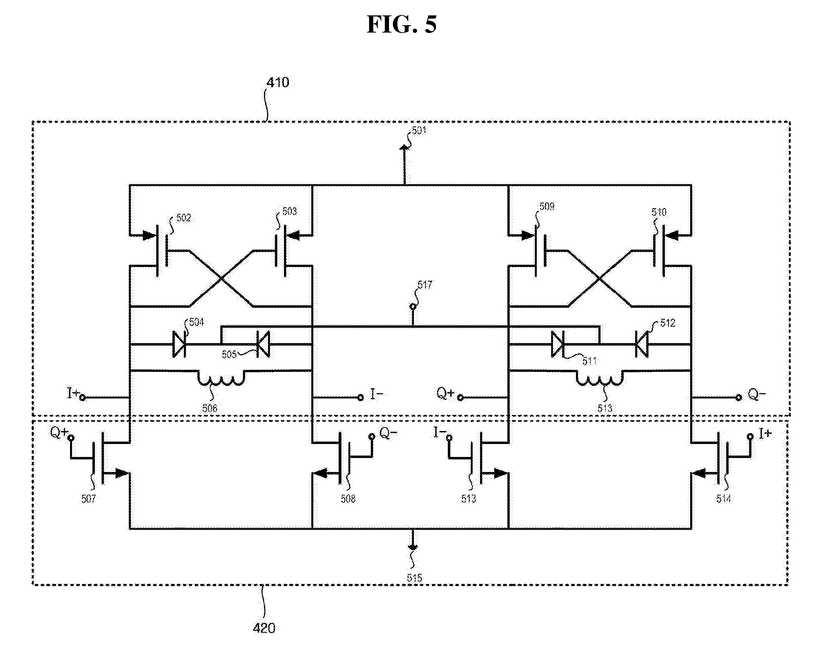

FIG. 5 is an exemplary circuit diagram of the quadrature voltage-controlled oscillator illustrated in FIG. 4, which specifically illustrates the oscillation module 410 and the coupling module 420.

Referring to FIG. 5, the quadrature voltage-controlled oscillator includes in-phase blocks 502 and 503, quad-phase blocks 509 and 510, coupling blocks 507, 508, 513, and 514 and LC tank blocks 504, 505, 506, 511, 512, and 513.

In this case, PMOS transistors 502 and 503 are used for in-phase oscillation, and PMOS transistors 509 and 510 are used for quad-phase oscillation.

NMOS transistors 507, 508, 513, and 514 are used for coupling to generate a quadrature signal.

Resonance is generated in the LC tank that consists of inductors 506 and 513 and diodes 504, 505, 511, and 512. In this case, the diodes are varactor diodes. The oscillation frequency is determined by changing a capacitance value according to the voltage provided via a terminal 517.

The output stage of the quadrature voltage controlled oscillator is denoted by I+, I-, Q+, and Q- in FIG. 5, each of which is connected to a gate terminal of the NMOS transistor composing the coupling module 420.

That is, I+ is connected to a gate terminal of the NMOS transistor 514, I-is connected to a gate terminal of the NMOS transistor 513, Q+ is connected to a gate terminal of the NMOS transistor 507, and Q- is connected to a gate terminal of the NMOS transistor 508.

The circuit of the in-phase unit and the circuit of a quad-phase are identical, each of which generates a differential signal having a phase difference of 180 degrees. The differential signals are denoted by I+, I-, Q+, and Q-.

The quadrature voltage-controlled oscillator illustrated in FIG. 5 is resonated by negative resistance generated by the PMOS transistors 502, 503, 509, and 510 composing the oscillation module 410. The resonance frequency can be calculated from Equation 1.

Referring to FIG. 5, when the coupling module 420 is connected to the bottom of the oscillation module 410, which may include PMOS transistors, and the coupling module 420 may include NMOS transistors.

An output signal of the quadrature voltage-controlled oscillator is connected to a drain of the NMOS transistor composing the coupling module 420.

FIGS. 4 and 5 illustrate that the coupling module 420 is connected to the bottom of the oscillation module 410. However, 410 and 420 may be located to the top of the module.

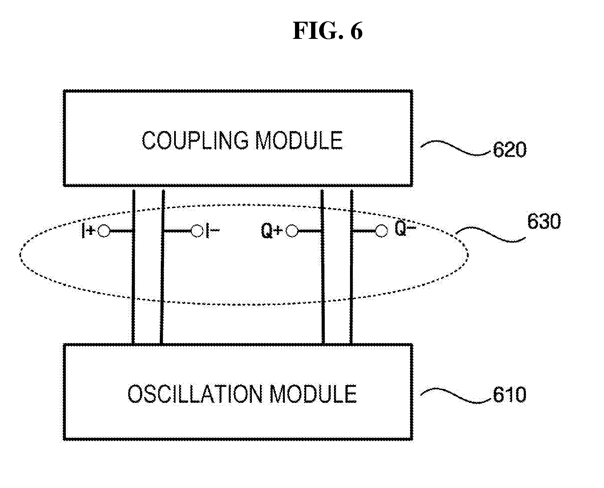

That is to say, as illustrated in FIG. 6, a quadrature voltage-controlled oscillator according to another exemplary embodiment of the present invention includes an oscillation module 610 and a coupling module 620, which may be connected to the bottom of the coupling module 620.

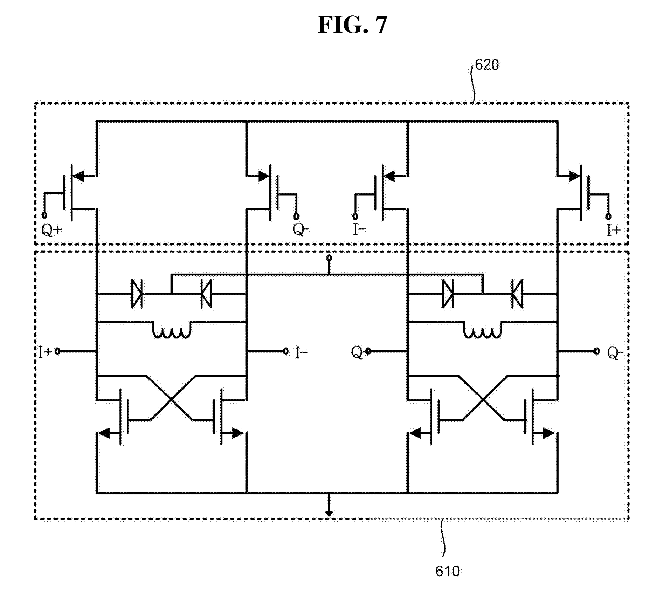

An exemplary circuit diagram of the oscillation module 610 and the coupling module 620 is illustrated in FIG. 7, and its basic structure is identical to the circuit diagram illustrated in FIG. 5.

The only difference is that the oscillation module 610 consists of NMOS transistors, while the coupling module 620 consists of PMOS transistors.

A simulation of the exemplary embodiment of the present invention was performed in a range of 4.8 to 6.1 GHz according to the IEEE802.11a standard. Here, it is assumed that the whole circuit is operated in 1.2 volts.

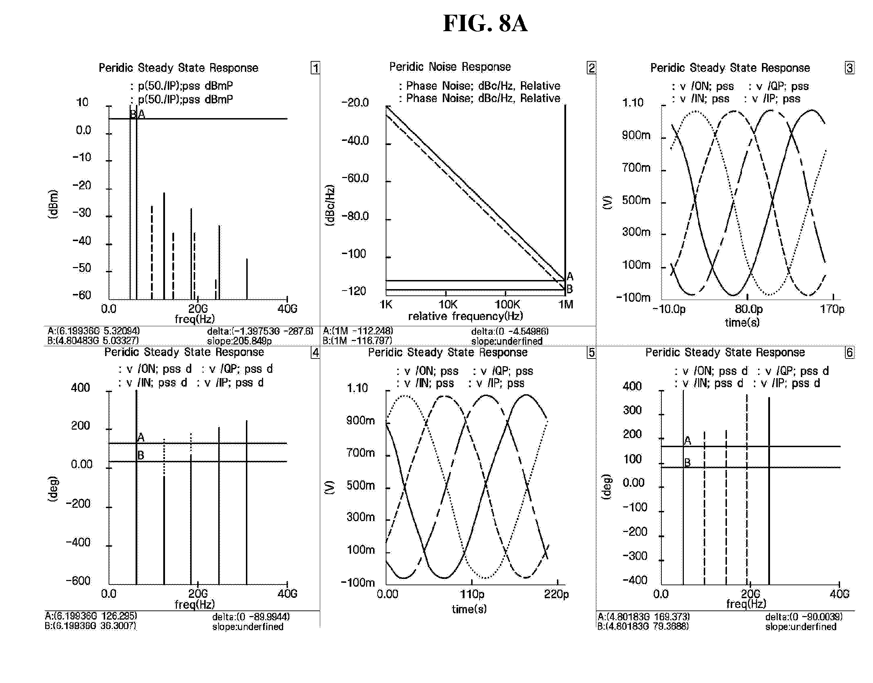

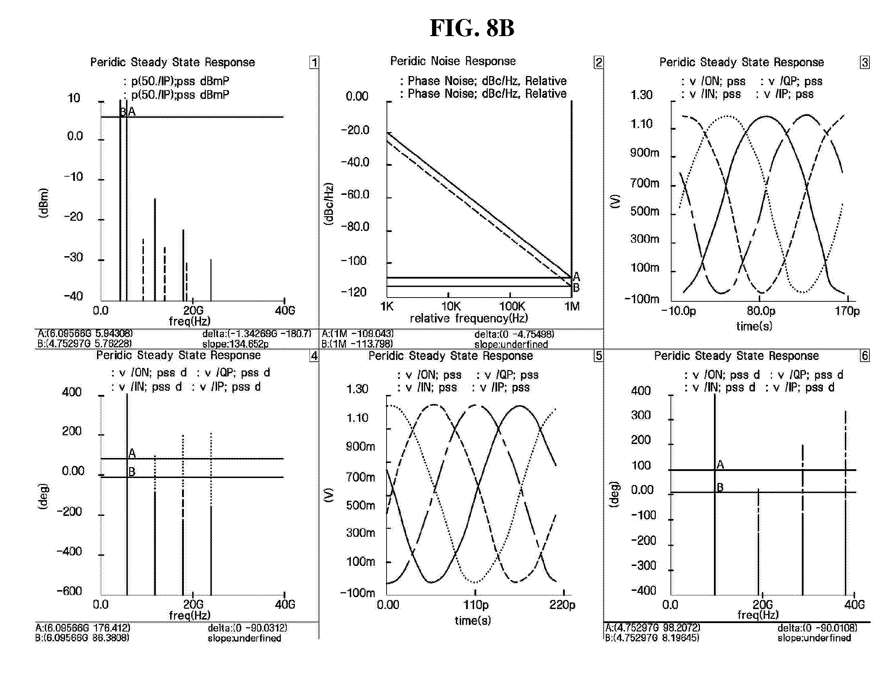

FIG. 8A is a graph showing the result of a simulation according of the related art, and FIG. 8B is a graph showing the result of a simulation according to the exemplary embodiment of the present invention. The results are as shown in Tables 1 and 2.

Table 1

|  | Phase Noise (dBc/Hz) | |
|---|---|---|
|  | @4.8GHz | @6.1GHz |
| Prior Art | -113.8 | -109.0 |
| Exemplary Embodiment of Present Invention | -116.8 | -112.2 |

Table 1 shows phase noises at different frequencies. The phase noise is for the case where offset frequency is 1 MHz. Referring to Table 1, a phase noise according to the exemplary embodiment of the present invention increases by about 3 dB in a range of 4.8 to 6.1 GHz than the phase noise according to the related art.

Table 2

|  | Phase Error (Deg.) | |
|---|---|---|
|  | @4.8GHz | @6.1GHz |
| Prior Art | 0.008 | 0.02 |
| Exemplary Embodiment of Present Invention | 0.004 | 0.006 |

Table 2 shows phase errors at different frequencies. Each of signals I+, I-, Q+, and Q- has to maintain a certain phase difference. When the signals cannot maintain the phase difference, the phase error indicates the phase difference. As shown in Table 2, the phase error can be reduced, and especially, is effective when the frequency is higher.

As shown in FIGS. 8A and 8B, the implementation of the exemplary embodiment of the present invention makes high-frequency elements smaller.

According to the exemplary embodiments of the present invention as described above, a phase noise or a phase error can be reduced by separating an oscillation unit from a coupling unit in a quadrature voltage-controlled oscillator, and a circuit can be simplified.

Although a quadrature voltage-controlled oscillator and a transceiver including the same have been described in connection with the exemplary embodiments of the present invention, it will be apparent to those skilled in the art that various modifications and changes may be made thereto without departing from the scope and spirit of the invention. Therefore, it should be understood that the above exemplary embodiments are not limitative, but illustrative in all aspects.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features. The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1. A quadrature voltage-controlled oscillator comprising:

   an oscillation module (410, 610) that provides a first signal and a second signal,

   wherein each of the first signal and the second signal has a predetermined frequency; and
   a coupling module (420, 620) that combines the first signal and the second signal in a manner such that the second signal has a quadrature phase difference with respect to the first signal.

2. The oscillator of claim 1, wherein each of the first signal and the second signal comprises a differential signal, wherein the differential signal of the first signal has a phase difference of 180 degrees with respect to the differential signal of the second signal.

3. The oscillator of claim 1 or claim 2, wherein the coupling module (420) is connected to a bottom portion of the oscillation module (410).

4. The oscillator of claim 3, wherein the oscillation module (410) comprises a plurality of PMOS transistors (502, 503, 509, 510), and the coupling module comprises a plurality of NMOS transistors (507, 508, 513, 514).

5. The oscillator of claim 4 or claim 5 wherein the oscillation module (410) does not include an NMOS transistor, and the coupling module (420) does not include a

6. The oscillator of claim 4 or claim 5, wherein a signal that flows in the PMOS transistor (502, 503, 509, 510) also flows in the NMOS transistor (507, 508, 513, 514).

7. The oscillator of claim 1, wherein the oscillation module (610) is connected to a bottom portion of the coupling module (620).

8. The oscillator of claim 6, wherein the oscillation module (610)comprises a plurality of NMOS transistors, and the coupling module (620) comprises a plurality of PMOS transistors.

9. The oscillator of claim 8, wherein the oscillation module (610) does not include an PMOS transistor, and the coupling module (620) does not include an NMOS transistor.

10. The oscillator of any one of claims 7 - 9, wherein a signal that flows in the NMOS transistor also flows in the PMOS transistor.

11. The oscillator of any preceding claim, wherein the oscillation module (410, 610) comprises an inductor-capacitor (LC) tank.

12. The oscillator of claim 11 wherein the LC tank comprises an inductor (506, 513) and a diode (504, 505, 511, 512).

13. The oscillator of any preceding claim, wherein the coupling module (420, 620) generates a quadrature frequency using an output signal of the quadrature voltage-controlled oscillator.

14. A wireless transceiver (300) comprising:

a low-noise amplifier (340) that amplifies a radio frequency (RF) signal;

a quadrature voltage-controlled oscillator (380) that provides an oscillation signal by separating an oscillating area from a coupling area;

a mixer (330) that outputs a baseband signal by mixing the amplified RF signal with the oscillation signal; and

a baseband processor (390) that processes the output baseband signal.

15. The transceiver (300) of claim 14, wherein the quadrature voltage-controlled oscillator (380) is according to any one of claims 1 - 13.

# FIG. 1(RELATED ART)

EP 1 764 911 A2

## FIG. 2(RELATED ART)

FIG. 3

# FIG. 4

OSCILLATION MODULE — 410

I+ ○— —○ I− Q+ ○— —○ Q−  — 430

COUPLING MODULE — 420

# FIG. 5

EP 1 764 911 A2

# FIG. 6

COUPLING MODULE — 620

I+ ◯— —◯I—    Q+ ◯— —◯ Q— — 630

OSCILLATION MODULE — 610

# FIG. 7

# FIG. 8A

**Periodic Steady State Response** [1]
: p(50./IP);pss dBmP
: p(50./IP);pss dBmP

(dBm) vs freq(Hz)

A:(6.19936G 5.32094)    delta:(-1.39753G -287.6)
B:(4.80483G 5.03327)    slope:205.849p

**Periodic Noise Response** [2]
: Phase Noise; dBc/Hz, Relative
: Phase Noise; dBc/Hz, Relative

(dBc/Hz) vs relative frequency(Hz)

A:(1M -112.248)    delta:(0 -4.54986)
B:(1M -116.797)    slope:underfined

**Periodic Steady State Response** [3]
: v /ON; pss    : v /QP; pss
: v /IN; pss    : v /IP; pss

(V) vs time(s)

**Periodic Steady State Response** [4]
: v /ON; pss d    : v /QP; pss d
: v /IN; pss d    : v /IP; pss d

(deg) vs freq(Hz)

A:(6.19936G 126.295)    delta:(0 -89.9944)
B:(6.19936G 36.3007)    slope:underfined

**Periodic Steady State Response** [5]
: v /ON; pss    : v /QP; pss
: v /IN; pss    : v /IP; pss

(V) vs time(s)

**Periodic Steady State Response** [6]
: v /ON; pss d    : v /QP; pss d
: v /IN; pss d    : v /IP; pss d

(deg) vs freq(Hz)

A:(4.80183G 169.373)    delta:(0 -90.0039)
B:(4.80183G 79.3688)    slope:underfined

EP 1 764 911 A2

# FIG. 8B

Peridic Steady State Response    1

: p(50./IP);pss dBmP
: p(50./IP);pss dBmP

(dBm)

A:(6.09566G 5.94308)     delta:(-1.34269G -180.7)
B:(4.75297G 5.76228)     slope:134.652p

Peridic Noise Response    2

: Phase Noise; dBc/Hz, Relative
: Phase Noise; dBc/Hz, Relative

(dBc/Hz)

A:(1M -109.043)     delta:(0 -4.75498)
B:(1M -113.798)     slope:underfined

Peridic Steady State Response    3

: v /ON; pss   : v /QP; pss
: v /IN; pss   : v /IP; pss

(V)

Peridic Steady State Response    4

: v /ON; pss d   : v /QP; pss d
: v /IN; pss d   : v /IP; pss d

(deg)

A:(6.09566G 176.412)     delta:(0 -90.0312)
B:(6.09566G 86.3808)     slope:underfined

Peridic Steady State Response    5

: v /ON; pss   : v /QP; pss
: v /IN; pss   : v /IP; pss

(V)

Peridic Steady State Response    6

: v /ON; pss d   : v /QP; pss d
: v /IN; pss d   : v /IP; pss d

(deg)

A:(4.75297G 98.2072)     delta:(0 -90.0108)
B:(4.75297G 8.19645)     slope:underfined

EP 1 764 911 A2